Europäisches Patentamt

European Patent Office

Office européen des brevets

(11) Veröffentlichungsnummer: **0 413 961 A1**

# EUROPÄISCHE PATENTANMELDUNG

(21) Anmeldenummer: 90113739.8

(22) Anmeldetag: 18.07.90

(51) Int. Cl.5: **H01R 9/09**

Geänderte Patentansprüche gemäss Regel 86 (2) EPÜ.

(30) Priorität: 23.08.89 DE 8910105 U

(43) Veröffentlichungstag der Anmeldung:
27.02.91 Patentblatt 91/09

(84) Benannte Vertragsstaaten:
DE ES FR GB IT SE

(71) Anmelder: Grote & Hartmann GmbH & Co. KG
Am Kraftwerk 13
D-5600 Wuppertal 21(DE)

(72) Erfinder: Zinn, Bernd
Peter-Alfs-Strasse 6
D-5828 Ennepetal(DE)
Erfinder: Haarscheidt, Uwe
Bergisch Born 128
D-5630 Remscheid(DE)

(74) Vertreter: Patentanwälte Dr. Solf & Zapf
Schlossbleiche 20 Postfach 13 01 13
D-5600 Wuppertal 1(DE)

(54) Kontaktelement für eine Leiterplatte.

(57) Die Erfindung betrifft ein elektrisches Kontaktelement als Durchkontaktierung einer Leiterplatte für die Erstellung einer beidseitigen Bestückung einer Leiterplatte mit elektrischen Bauelementen zu einer elektronischen Baugruppe nach der Oberflächenmontagetechnologie (SMT), wobei das Kontaktelement ein Loch in der Leiterplatte durchgreift und auf einer Seite der Leiterplatte mit einem Kontaktteil der Leiterplatte durch Tauch- oder Schwallötung elektrisch kontaktierend verlötet ist, wobei es aus einem Blechstanzteil besteht und ein das Loch der Leiterplatte durchgreifendes Lötbein aufweist, an das an dem der Tauch- oder Schwallötstelle gegenüberliegenden Bereich ein Kontaktstück angebunden ist, das auf der Leiterplatte mit einem Kontaktteil der Leiterplatte über eine erhärtete Lötpastenschicht in Verbindung steht.

FIG.1

EP 0 413 961 A1

## KONTAKTELEMENT FÜR EINE LEITERPLATTE.

Die Erfindung betrifft ein elektrisches Kontaktelement aus einem Blechstanzteil für eine Leiterplatte.

Leiterplatten, die zur Verbindung von elektronischen Bauelementen zu einer Baugruppe durch Oberflächenmontage nach der sogenannten SMT-Methode (Surface Mount Technologies) dienen, können beidseitig Leiterbahnen oder dergleichen elektrische Kontaktelemente aufweisen. Für die Fertigung einer Baugruppe kann es erforderlich sein, einen Kontakt auf der einen Seite der Leiterplatte mit einem Kontakt auf der anderen Seite der Leiterplatte durchzukontaktieren. Zu diesem Zweck werden in einem gesonderten Verfahrensschritt vor der Oberflächenmontage Löcher in die Leiterplatte eingebracht, in die Löcher metallische Hülsen eingesetzt und die Hülsenenden beidseitig mit den Kontakten der Leiterplatte verlötet. Eine andere Verfahrensweise sieht vor, die Löcherwandungen zu metallisieren, so daß ein beidseitiger Kontakt mit den Kontakten der Leiterplatte entsteht. Die insoweit vorgefertigte Leiterplatte ist somit lediglich für eine bestimmte Baugruppe verwendbar. Die Herstellung der Durchkontaktierungen ist aufwendig und zeitraubend.

Aufgabe der Erfindung ist, eine Möglichkeit der Durchkontaktierung während der Oberflächenmontage zu schaffen, so daß die Verfügbarkeit von Leiterplatten erhöht wird.

Diese Aufgabe wird durch die Merkmale des Anspruchs 1 gelöst; vorteilhafte Weiterbildung der Erfindung werden in den Unteransprüchen gekennzeichnet.

Die Erfindung schafft ein einfach aufgebautes elektrisches Kontaktelement, mit dem die Kontaktierung eines Kontakts auf der einen Seite der Leiterplatte mit einem Kontakt auf der anderen Seite der Leiterplatte problemlos und einfach gelingt, wobei die Kontaktierung während der Oberflächenmontage der elektrischen Bauelemente automatisch ausführbar ist. Dabei können die Löcher vom Roboter unmittelbar vor der Durchkontaktierung gebohrt oder gestanzt werden, woraufhin das elektrische Kontaktelement positioniert und durch Einwirkung von Wärme mit einer Lötmittelschicht auf der Leiterplatte fixiert wird.

An Hand von in der Zeichnung dargestellten Ausführungsbeispielen wird die Erfindung im folgenden erläutert.

Es zeigen:

Fig. 1 Eine Frontansicht des in die Leiterplatte eingesetzten Kontaktelements.

Fig. 2 Eine Seitenansicht des in die Leiterplatte eingesetzten Kontaktelements.

Fig. 3 Eine Draufsicht auf das in die Leiterplatte eingesetzte Kontaktelement.

Fig. 4 bis 18 Kontaktelemente in verschiedenen Ausgestaltungen jeweils in der Frontansicht, Seitenansicht und Draufsicht.

Das Kontaktelement 1 aus einem Blechstanzteil weist einen im wesentlichen runden ebenen Deckel 2 auf. In den Deckel 2 sind von der Deckelaussenkante 3 ausgehend zwei parallel zueinander verlaufende Einschnitte 4,5 eingebracht, die sich bis etwa zu einer Durchmesserlinie 6 erstrecken und beiderseits im gleichen Abstand von der zur Durchmesserlinie 6 senkrecht liegenden Durchmesserlinie 7 angeordnet sind. Durch die Einschnitte 4,5 wird ein Anbindungslappen 8 gebildet, an den einstückig ein Lötbein 11 in Form eines Lötbeinstegs 11 a angebunden ist, wobei der Anbindungslappen 8 aus der Ebene des Deckels 2 über ein s-förmiges Bogenstück 10 zu einer senkrechten Ebene 9, in der die Durchmesserlinie 6 liegt, abgebogen ist, so daß der Lötbeinsteg 11 a sich in der Ebene 9 mittig unter dem Deckel 2 befindet. Der Lötbeinsteg 11 a ist breiter ausgeführt als der Anbindungslappen 8 und weist an seinen Längskanten 12 jeweils mindestens einen über die Kanten 12 nach aussen vorstehenden, sägezahnförmigen Verankerungsvorsprung 13 auf. Die Längskanten 12 laufen im Bereich der freien Unterkante 14 des Lötbeinstegs 11 a v-förmig aufeinander zu, so daß ein angespitztes Lötbeinstegende 15 gebildet wird.

Das erfindungsgemäße Kontaktelement 1 steckt mit dem Anbindungslappen und mindestens mit dem mit den Verankerungsvorsprüngen 13 versehenen Bereich des Lötbeinstegs 11 a in einem vorzugsweise runden Loch 16 einer Leiterplatte 18, wobei sich die Verankerungsvorsprünge 13 in der Wandung 17 verhakt haben, so daß das erfindungsgemäße Kontaktelement 1 unverlierbar in der Leiterplatte 18 sitzt, und der Deckel 2 sich auf der Oberfläche der Leiterplatte 18 abstützt. Der Durchmesser des Lochs 16 entspricht der Breite des Lötbeinstegs 11 a zwischen den Längskanten 12, wobei der Durchmesser des Deckels 2 größer ist, als der Durchmesser des Lochs 16.

Der Deckel 2 liegt auf einer verfestigten, das Loch 16 umgebenden Lötpastenschicht 19 auf, die elektrisch kontaktierend auf einer Leiterbahn 20 der Leiterplatte 18 aufsitzt.

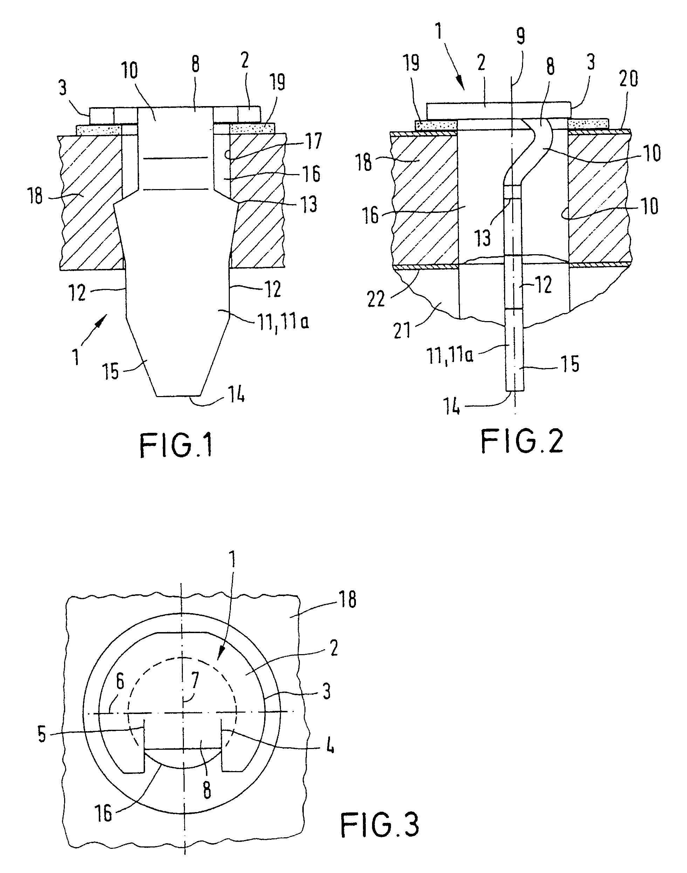

Auf der anderen Seite der Leiterplatte 18 überragt ein Lötbein steg 11 a zumindest mit seinem angespitzten Lötbeinende 15 die Leiterplatte 18, wobei ein Lötpunkt 21 aus Lötmetall einen elektrischen Kontakt zwischen dem Lötbeinsteg 11 a und einer auf der Leiterplatte 18 angeordneten weiteren Leiterbahn 22 gewährleistet (Fig. 2).

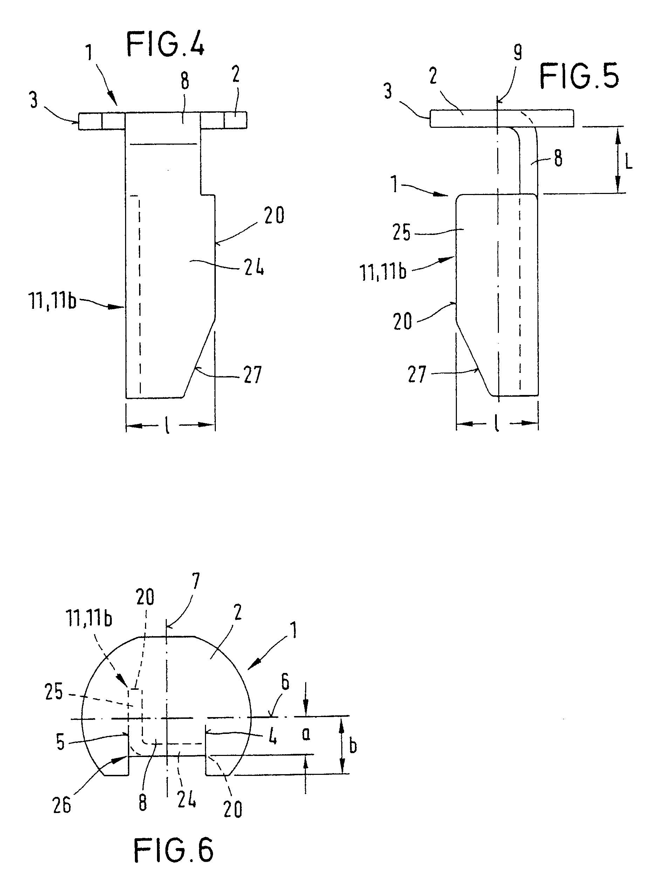

Die Ausgestaltung nach den Figuren 4 bis 18 unterscheiden sich von der vorbeschriebenen Ausgestaltung durch eine andere Form des Lötbeins 11 des Kontaktelements 1. Bei der Ausgestaltung gemäß Figuren 1 bis 3 wird das Lötbein 11 durch den flachen Lötbeinsteg 11 a gebildet, der aufgrund seiner flachen Ausbildung im wesentlichen nur an zwei einander diametral gegenüberliegenden Stellen mit der Wandung 17 des Lochs 16 in Berührung steht. Hierdurch ist zwar eine sichere Halterung des Kontaktelements 1 gewährleistet, jedoch sind aufgrund der sich in den Berührungspunkten nahezu tangential erstreckenden Wandung geringe Abweichungen des Kontaktelements von seiner gegenüber dem Loch 16 zentralen bzw. koaxialen Lage möglich.

Es besteht auch die Forderung nach einer stabilen Ausgestaltung für das Lötbein 11, wobei beim Einstecken des Kontaktelements 1 in das Loch 16 Verbiegungen des Lötbeins 11 ausgeschlossen sein sollen.

Den vorbeschriebenen Forderungen nach zentraler Anordnung des Kontaktelements 1 und stabiler Ausgestaltung des Lötbeins 11 wird insbesondere mit den Ausgestaltungen gemäß Fig. 4 bis 18 Rechnung getragen, bei denen das Lötbein 11 im Querschnitt eine von einer Ebene abweichende Profilierung aufweist und dabei an wenigstens drei auf den Umfang verteilt angeordneten Stellen mit der Wandung 17 des Lochs 16 in Kontakt steht. Hierdurch wird die zentrale Anordnung des Lötbein2 11 und somit auch des Kontaktelements 1 insgesamt erreicht. Die angestrebte Stabilität des Lötbeins 11 ergibt sich aufgrund der Profilierung.

Bei der Ausgestaltung nach Figuren 4 bis 6 ist das Lötbein 11 im Querschnitt winkelförmig geformt, so daß sich ein Lötbein-Winkelsteg 11 b ergibt mit zwei rechtwinklig zueinander angeordneten Schenkein 24, 25, von denen der Schenkel 24 sich rechtwinklig zu den Einschnitten 4,5 und parallel zur senkrechten Mittelebene 9 erstreckt. Gegenüber dem Steg 11 a der Ausgestaltung nach Figuren 1 bis 3 ist hier der Schenkel 24 um das Maß a außermittig versetzt. Die Länge 1 der Schenkel 24, 25 kann gleich oder unterschiedlich sein. Wesentlich ist, daß sich eine Anlage an der Wandung 17 des Lochs 16 an drei auf dem Umfang verteilten Stellen bzw. Linien vorhanden ist. Da sich bei der vorliegenden Ausgestaltung die Schenkel 24, 25 in Längsrichtung des Lötbeins 11 parallel erstrecken, besteht eine linienförmige Anlage des Winkelstegs 11 b an der Wandung 17 an den freien Längskanten der Schenkel 24, 25 und im mit 26 bezeichneten Scheitel des Winkelstegs 11 b. Die Anspitzung des Winkelstegs 11 b wird hier durch Abschrägungen 27 der freien Ecken der Schenkel 24, 25 erreicht.

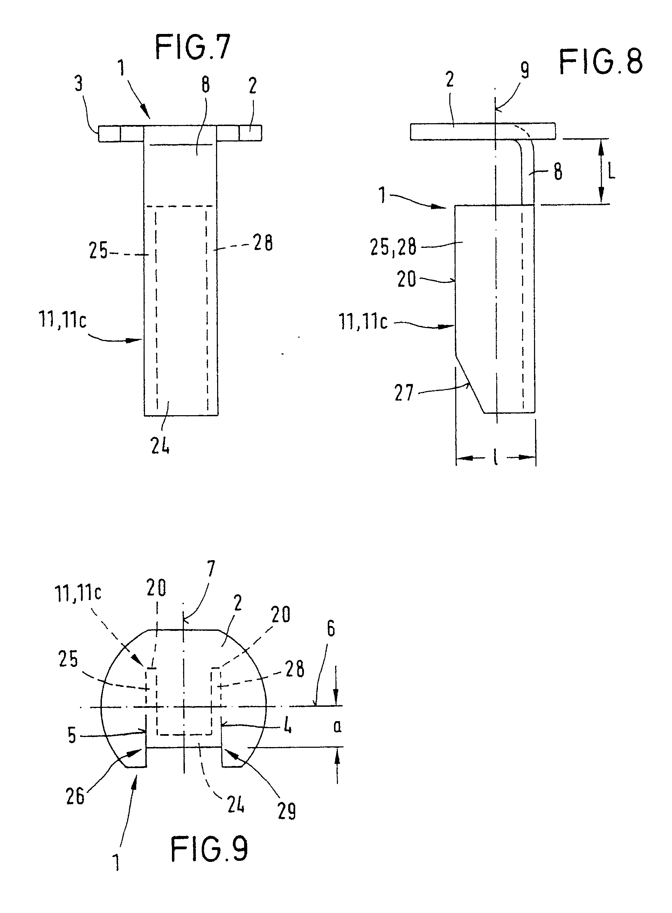

Bei der Ausgestaltung nach Figuren 7 bis 9 ist der Winkelsteg 11 b der Ausgestaltung nach Figuren 4 bis 6 durch einen weiteren dem Schenkel 25 gegenüberliegenden Schenkel 28 zu einer U-Form mit im wesentlichen rechteckigen Querschnitt ergänzt. Bei dieser Ausgestaltung ist die Querschnitts- Größenbemessung so getroffen, daß der so gebildete U-Steg 11 c mit den freien Längskanten 20 seiner Schenkel 25, 28 und seinen Ekken bzw. Scheiteln 26, 29 linienförmig an der Wandung 17 des Lochs 16 anliegt. Die Anspitzung wird hier durch Abschrägungen 27 der freien Ecken der Schenkel 25 und 28 erreicht.

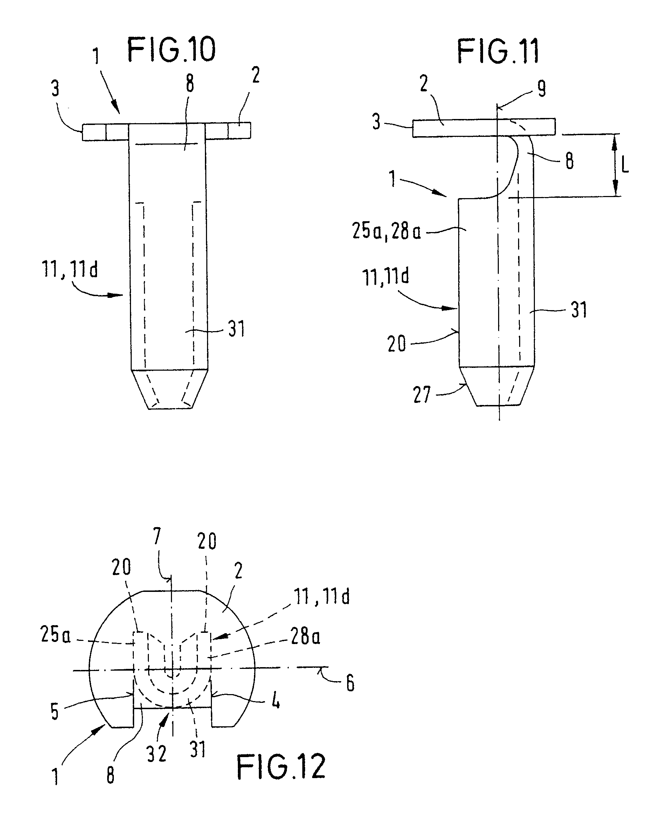

Von der vorbeschriebenen Ausgestaltung unterscheidet sich die Ausgestaltung nach Figuren 10 bis 12 dadurch, daß der hier mit 11 d bezeichnete U-Steg im Gegensatz zur im wesentlichen viereckigen Form die Form eines im Stegbereich kreisbogenförmig gerundeten U's aufweist, wobei der Stegabschnitt 31 dieses UStegs 11 d in die Schenkel übergehend kreisbogenförmig gerundet ist. mit einem Radius, der geringer ist als der Radius der Wand 17. Die Anordnung ist so getroffen, daß die freien Längskanten 20 der hier mit 25 a und 28 a bezeichneten Schenkel und der Scheitel 32 dieses U-Stegs 11 d linienförmig an der Wandung 17 der Bohrung 16 anliegen. Die Anspitzung kann wie bei dem vorhergehenden Ausführungsbeispiel durch Abschrägungen 27 der beiden freien Schenkelekken erfolgen. Bei der in Figuren 10 bis 12 dargestellten Ausgestaltung ist die Anspitzung durch eine konvergente Formgebung bzw. kegelstumpfförmige Verjüngung des freien Endes des U-Stegs 11 d gebildet, was durch ein Eindrücken bzw. Einprägen der Wand des U-Stegs 11 d vorzugsweise auf seinem gesamten Umfang in einfacher Weise erreicht werden kann. Dabei können die Abschrägungen 27 allein oder zusätzlich vorhanden sein.

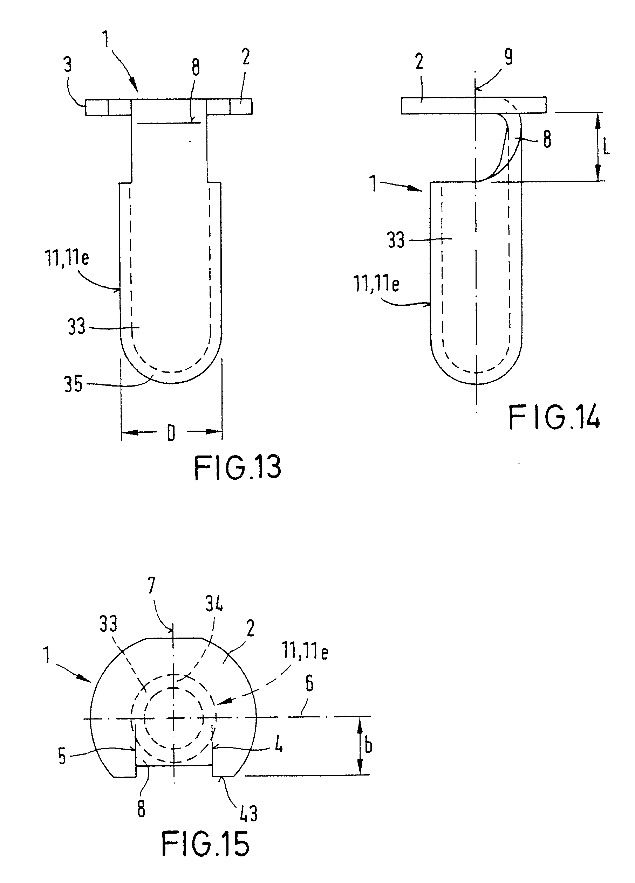

Bei der Ausgestaltung nach Figuren 13 bis 15 ist ein Lötbein-Hülsensteg 11 e vorgesehen, der an seiner Spitze verjüngt oder vorzugsweise kugelförmig gerundet, insbesondere durch einen hohlkugelförmigen Boden verschlossen ist. Die koaxial zum runden Deckel 2 angeordnete Hülse 33 ist um ihre Längsachse aus einem Blechstreifen gebogen, wobei zwei seitliche Blechstreifenteile aufeinanderzu gebogen sind, so daß auf einer Seite, insbesondere der dem Anbindungslappen 8 abgewandten Seite eine Stoßfuge 34 zwischen den Blechstreifenteilen vorhanden ist. Der hohlkugelförmige Boden 35 kann dabei in bekannter Weise nach Art von Kontakthülsen mit kuppelförmig geschlossenen Enden ausgebildet sein. Der Außendurchmesser D des Hülsenstegs 11 e ist an den Durchmesser des vorzugsweise runden Lochs 16 angepasst, so daß der Hülsensteg 11 e mit geringem Bewegungsspiel bzw. schließend in das Loch 16 eingeschoben werden kann.

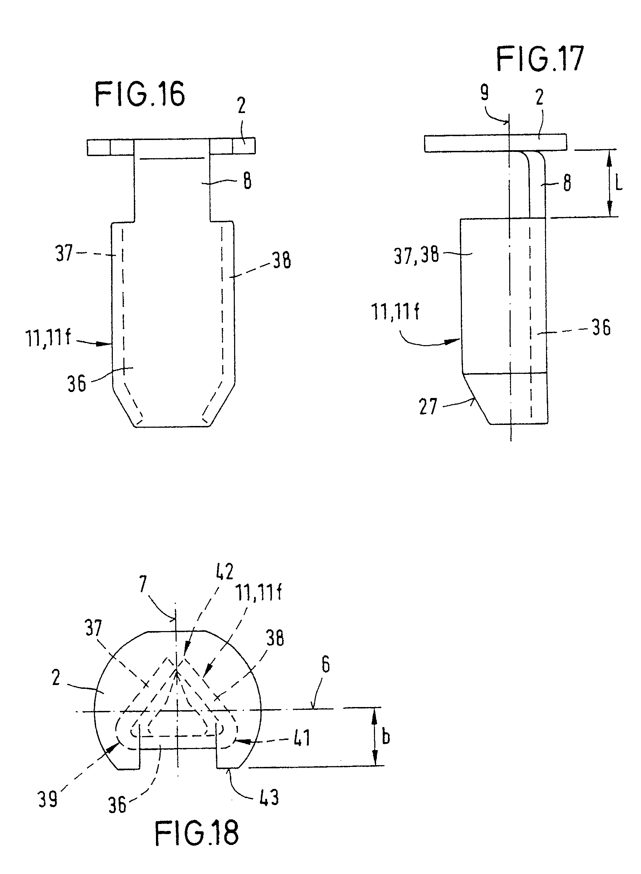

Bei der Ausgestaltung nach den Figuren 16 bis 18 ist ein Lötbein-Dreiecksteg 11 f in Form eines Hohlprofils vorgesehen, bestehend aus einem in Verlängerung des Anbindungslappens 8 angeordneten Stegteil 36 und seitlich davon ausgehenden Schenkein 37, 38, die zur dem Anbindungslappen 8 abgewandten Seite hin so aufeinanderzu abgewinkelt sind, daß ihre Längskanten aneinander anliegen oder einen geringen Abstand voneinander aufweisen. Die Schenkel 37, 38 und des Stegteils 36 bzw. der Querschnitt des Dreieckssteg 11 f ist so bemessen, daß die Scheitel 39, 41 und die Längsränder 42 der Schenkel 37, 38 bzw. die Ecken des Dreicksstegs 11 f in der in die Bohrung 16 eingeschobenen Stellung Berührungskontakt mit der Wandung 17 haben. Hierdurch ist an drei Stellen bzw. Linien die Anlage an der Wandung 17 gewährleistet, wodurch sich eine definierte zentrale Stellung des Dreieckstegs 11 f gegenüber der Bohrung 16 ergibt. Dabei kann der Dreiecksteg 11 f von gleichschenkliger Dreieckform oder auch einer anderen Dreieckform sein, wobei die Kantenlängen entsprechend zu bemessen sind. Um das Einschieben in die Bohrung 16 zu erleichtern, ist auch der Dreicksteg 11 f angespitzt. Vorzugsweise sind das Stegteil 36 und/oder die Schenkel 37, 38 bzw. die Ecken 39, 41 am freien Ende durch schrägen Verlauf konvergent, eingebogen oder geprägt, so daß sich eine verjüngte Spitze ergibt. Zusätzlich können auch ähnlich wie bei den vorbeschriebenen Ausführungsbeispielen die freien Ecken der Schenkel 37, 38 Abschrägungen 27 aufweisen, die in Figur 17 angedeutet sind.

Bei allen Ausgestaltungen wird das Kontaktteil 1 einteilig aus einem Blechstanzteil gestanzt und gebogen bzw. geprägt. Um für die Blechstreifen der Lötbeine 11 genügend Breite zur Verfügung zu haben, ist die Abbiegelänge L des Anbindungslappens 8 größer bemessen, als der Abstand b zwischen der die Mittelachse schneidenden Durchmesserlinie 6 und eine sekantiale Abflachung 43 des im wesentlichen runden Deckels 2.

Das Bestücken der Leiterplatte 18 mit den Kontaktelementen 1 erfolgt vorzugsweise mittels eines nicht dargestellten Sauggreifers, mit dem die Kontaktelemente 1 an der Oberseite des Deckels 2 ergriffen bzw. angesaugt und mit den Lötbeinen 11 in die Löcher 16 eingesetzt werden.

Mit der Erfindung gelingt auf besonders einfache Art und mit einfachen Mitteln Durchkontaktierungen bei Leiterplatten vorzusehen und zwar während der Oberflächenmontage der elektrischen Kontakte, so daß das Anbringen von Löchern 16 und das Einsetzen von erfindungsgemäßen Kontaktelementen 1 sowie das Löten programmierbar mit einem Roboter ausführbar ist.

**Ansprüche**

1. Elektrisches Kontaktelement als Durchkontaktierung einer Leiterplatte für die Erstellung einer beidseitigen Bestükkung einer Leiterplatte mit elektrischen Bauelementen zu einer elektronischen Baugruppe nach der Oberflächenmontagetechnologie (SMT), wobei das Kontaktelement ein Loch in der Leiterplatte durchgreift und auf einer Seite der Leiterplatte mit einem Kontaktteil der Leiterplatte durch Tauch- oder Schwallötung elektrisch kontaktierend verlötet ist,
**dadurch gekennzeichnet,**
daß es aus einem Blechstanzteil besteht und ein das Loch (16) der Leiterplatte (18) durchgreifendes Lötbein (11) aufweist, an das an dem der Tauch- oder Schwallötstelle gegenüberliegenden Bereich ein Kontaktstück (2) angebunden ist, das auf der Leiterplatte (18) mit einem Kontaktteil der Leiterplatte über eine erhärtete Lötpastenschicht (19) in Verbindung steht.

2. Kontaktelement nach Anspruch 1,
**dadurch gekennzeichnet,**
daß das Kontaktstück (2) ein Deckel ist, der sich rechtwinklig zum Lötbein (11) erstreckt.

3. Kontaktelement nach Anspruch 2,
**dadurch gekennzeichnet**
daß der Deckel (2) im wesentlichen kreisrund und ebenflächig ist.

4. Kontaktelement nach Anspruch 3,
**dadurch gekennzeichnet,**
daß in den Deckel (2) von der Aussenkante (3) ausgehend zwei parallel zueinander verlaufende Einschnitte (4), (5) eingebracht sind, die sich bis etwa zu einer ersten Durchmesserlinie (6) erstrecken und beiderseits im gleichen Abstand von der zur Durchmesserlinie (6) senkrecht liegenden zweiten Durchmesserlinie (7) angeordnet sind, wobei durch die Einschnitte (4, 5) ein Anbindungslappen (8) gebildet wird, an dem einstückig das Lötbein (11) angebunden ist.

5. Kontaktelement nach Anspruch 4,
**dadurch gekennzeichnet,**
daß das Lötbein (11) ein im wesentlichen ebener Lötbeinsteg (11a) ist, der sich etwa in der die erste Durchmesserlinie (6)enthaltenden, senkrecht zum Deckel (2) verlaufenden Ebene (9) erstreckt und der Anbindungslappen (8) aus der Ebene des Deckels (2) vorzugsweise über ein s-förmiges Bogenstück (10) zur senkrechten Ebene (9) abgebogen ist.

6. Kontaktelement nach Anspruch 5,
**dadurch gekennzeichnet,**
daß der Lötbeinsteg (11a) breiter ausgeführt ist als der Anbindungslappen (8) und an seinen Längskanten (12) jeweils mindestens einen über die Kanten (12) nach außen vorstehenden, sägezahnförmigen Verankerungsvorsprung (13) aufweist und die Verankerungsvorsprünge (13) in der Wandung (17) des Lochs (16) der Leiterplatte (18) verhakt sind.

7. Kontaktelement nach einem oder mehreren der Ansprüche 1 bis 6,
**dadurch gekennzeichnet,**
daß sich der Deckel (2) auf der Oberfläche der Leiterplatte (18) abstützt.

8. Kontaktelement nach Anspruch 7,
**dadurch gekennzeichnet,**
daß der Durchmesser des Deckels (2) größer ist, als der Durchmesser des Lochs (16).

9. Kontaktelement nach einem oder mehreren der Ansprüche 1 bis 8,
**dadurch gekennzeichnet,**
daß die Längskanten (12) des Lötbeinstegs (11) im Bereich der freien Unterkante (14) v-förmig aufeinanderzulaufen, so daß ein angespitztes Lötbeinstegende (15) gebildet wird.

10. Kontaktelement nach einem oder mehreren der Ansprüche 1 bis 9,
**dadurch gekennzeichnet,**
daß das Lötbein (11b bis 11f) ein sich in seiner Längsrichtung erstreckendes Profil mit quer zueinander gerichteten Profilwänden aufweist.

11. Kontaktelement nach Anspruch 10,
**dadurch gekennzeichnet,**
daß das Profil kastenförmig ist oder ein Hohlprofil ist.

12. Kontaktelement nach Anspruch 10 oder 11,
**dadurch gekennzeichnet,**
daß das Profil winkel-, C-, oder U-förmig ist.

13. Kontaktelement nach Anspruch 11 oder 12,
**dadurch gekennzeichnet,**
daß das Hohlprofil rund, insbesondere kreisrund oder dreieckig ist.

14. Kontaktelement nach Anspruch 13,
**dadurch gekennzeichnet,**
daß das Hohlprofil durch eine Hülse (33) oder Rohr mit einer Längsfuge (34) gebildet ist, die vorzugsweise auf der dem Anbindungslappen (8) abgewandten Seite verläuft.

15. Kontaktelement nach Anspruch 14,
**dadurch gekennzeichnet,**
daß die Hülse (33) an ihrem freien Ende einen vorzugsweise kuppelförmigen Boden (35) aufweist.

16. Kontaktelement nach einem oder mehreren der Ansprüche 10 bis 15,
**dadurch gekennzeichnet,**
daß der Querschnitt oder die Querkantenlängen des Profils so groß bemessen ist bzw. sind, daß es im in das Loch (16) der Leiterplatte (18) eingesetzten Zustand an wenigstens drei oder vier auf seinem Umfang verteilten Stellen, vorzugsweise mit seinen Profilekken bzw. Profilscheiteln (26,29;32;39,41) und/oder den Längskanten (20) seiner Profilschenkel (24,25;28;37, 38) in Berührungskontakt mit der Wandung (17) des Lochs (16) steht.

17. Kontaktelement nach einem oder mehreren der Ansprüche 14 bis 16,
**dadurch gekennzeichnet,**
daß der Durchmesser (D) der Hülse (33) an die entsprechende Abmessung des vorzugsweise runden Lochs (16) angepaßt ist und die Hülse (33) im in das Loch (16) eingesteckten Zustand mit ihrer Mantelfläche in Berührungskontakt mit der Wandung (17) der Bohrung (16) steht.

18. Kontaktelement nach einem oder mehreren der Ansprüche 4 bis 17,
**dadurch gekennzeichnet,**
daß der Anbindungslappen (8) S- oder winkelförmig gebogen ist.

19. Kontaktelement nach einem oder mehreren der Ansprüche 10 bis 18,
**dadurch gekennzeichnet,**
daß der sich außermittig zum Deckel (2) erstreckende Anbindungslappen (8) mit dem sich auf der gleichen Seite des Kontaktelements (1) befindlichen Wandteil (24;31;33;36) des Profils verbunden ist.

20. Kontaktelement nach einem oder mehreren der Ansprüche 1 2 bis 19,
**dadurch gekennzeichnet,**
daß bei einem winkel-, C-, oder U-förmigen Profil der Anbindungslappen (8) mit einem mit seinem Längsschenkel fluchtenden oder zu ihm im wesentlichen parallel verlaufenden Schenkel (24) oder Steg (31;36) des Profils verbunden ist.

Geänderte Patentansprüche gemäss Regel 86(2) EPÜ.

1. Elektrisches Kontaktelement als Durchkontaktierung einer Leiterplatte für die Erstellung einer beidseitigen Bestükkung einer Leiterplatte mit elektrischen Bauelementen zu einer elektronischen Baugruppe nach der Oberflächenmontage-Technologie (SMT), wobei das Kontaktelement ein Loch in der Leiterplatte durchgreift, auf einer Seite der Leiterplatte mit einem Kontaktteil der Leiterplatte durch Tauch-oder Schwallötung elektrisch kontaktierend verlötet ist, aus einem Blechteil besteht und ein das Loch der Leiterplatte durchgreifendes Lötbein aufweist, an das an dem der Tauch- oder Schwallötstelle gegenüberliegenden Bereich ein Kontaktstück angebunden ist, das auf der Leiterplatte mit einem Kontaktteil der Leiterplatte in Verbindung steht, dadurch **gekennzeichnet.**
daß das Kontaktstück ein im wesentlichen kreisrund und ebenflächig ausgebildeter Deckel (2) ist, der sich rechtwinkelig zum Lötbein (11) erstreckt und dessen Verbindung mit dem Kontaktteil über eine erhärtete Lötpastenschicht (19) erfolgt, und daß in den Deckel (2) vond er Außenkante (3) ausgehend zwei parallel zueinander verlaufende Einschnitte (4,5) eingebracht sind, die sich bis etwa zu einer ersten Durchmesserlinie (6) erstrecken und beiderseits im gleichen Abstand von der zur Durchmesserlinie (6) senkrecht liegenden zweiten Durchmesserlinie (7) angeordnet sind, wobei durch die Einschnitte (4,5) ein Anbindungslappen (8) gebildet wird, an dem einstückig das Lötbein (11) angebunden ist.

2. Kontaktelement nach Anspruch 1,
**dadurch gekennzeichnet,**
daß das Lötbein (11) ein mit wesentlichen ebener Lötbeinsteg (11a) ist, der sich etwa in der die erste Durchmesserlinie (6) enthaltenden, senkrecht zum Deckel (2) verlaufenden Ebene (9) erstreckt und der Anbindungslappen (8) aus der Ebene des Deckels (2) vorzugsweise über ein s-förmiges Bogenstück (10) zur senkrechten Ebene (9) abgebogen ist.

3. Kontaktelement nach Anspruch 2,
**dadurch gekennzeichnet,** daß der Lötbeinsteg (11a) breiter ausgeführt ist als der Anbindungslappen (8) und an seinen Längskanten (12) jeweils mindestens einen über die Kanten (12) nach außen vorstehenden, sägezahnförmigen Verankerungsvorsprung (13) aufweist und die Verankerungsvorsprünge (13) in der Wandung (17) des Lochs (16) der Leiterplatte (18) verhakt sind.

4. Kontaktelement nach einem oder mehreren der Ansprüche 1 bis 3,
**dadurch gekennzeichnet,**
daß sich der Deckel (2) auf der Oberfläche der Leiterplatte (18) abstützt.

5. Kontaktelement nach Anspruch 4,
**dadurch gekennzeichnet,**
daß der Durchmesser des Deckels (2) größer ist, als der Durchmesser des Lochs (16).

6. Kontaktelement nach einem oder mehreren der Ansprüche 1 bis 5,
**dadurch gekennzeichnet,**
daß die Längskanten (12) des Lötbeinstegs (11) im Bereich der freien Unterkante (14) v-förmig aufeinanderzulaufen, so daß ein angespitztes Lötbeinstegende (15) gebildet wird.

7. Kontaktelement nach einem oder mehreren der Ansprüche 1 bis 6,
**dadurch gekennzeichnet,**
daß das Lötbein (11b bis 11f) ein sich in seiner Längsrichtung erstreckendes Profil mit quer zueinander gerichteten Profilwänden aufweist.

8. Kontaktelement nach Anspruch 7,
**dadurch gekennzeichnet,**
daß das Profil kastenförmig ist oder ein Hohlprofil ist.

9. Kontaktelement nach Anspruch 7 oder 8,
**dadurch gekennzeichnet,**
daß das Profil winkel-, C-, oder U-förmig ist.

10. Kontaktelement nach Anspruch 8 oder 9,
**dadurch gekennzeichnet,**
daß das Hohlprofil rund, insbesondere kreisrund oder dreieckig ist.

11. Kontaktelement nach Anspruch 10,
**dadurch gekennzeichnet,**
daß das Hohlprofil durch eine Hülse (33) oder Rohr mit einer Längsfuge (34) gebildet ist, die vorzugsweise auf der dem Anbindungslappen (8) abgewandten Seite verläuft.

12. Kontaktelement nach Anspruch 11,
**dadurch gekennzeichnet,**
daß die Hülse (33) an ihrem freien Ende einen vorzugsweise kuppelförmigen Boden (35) aufweist.

13. Kontaktelement nach einem oder mehreren der Ansprüche 7 bis 12,
**dadurch gekennzeichnet,**
daß der Querschnitt oder die Querkantenlängen des Profils so groß bemessen ist bzw. sind, daß es im in das Loch (16) der Leiterplatte (18) eingesetzten Zustand an wenigstens drei oder vier auf seinem Umfang verteilten Stellen, vorzugsweise mit seinen Profilekken bzw. Profilscheiteln (26,29;32;39;41) und/oder den Längskanten (20) seiner Profilschenkel (24,25;28;37,38) in Berührungskontakt mit der Wandung (17) des Lochs (16) steht.

14. Kontaktelement nach einem oder mehreren der Ansprüche 11 bis 13,
**dadurch gekennzeichnet,**
daß der Durchmesser (D) der Hülse (33) an die entsprechende Abmessung des vorzugsweise runden Lochs (16) angepaßt ist und die Hülse (33) im in das Loch (16) eingesteckten Zustand mit ihrer Mantelfläche in Berührungskontakt mit der Wandung (17) der Bohrung (16) steht.

15. Kontaktelement nach einem oder mehreren der Ansprüche 1 bis 14,
**dadurch gekennzeichnet,**
daß der Anbindungslappen (8) S- oder winkelförmig gebogen ist.

16. Kontaktelement nach einem oder mehreren der Ansprüche 7 bis 15,
**dadurch gekennzeichnet,**
daß der sich außermittig zum Deckel (2) erstreckende Anbindungslappen (8) mit dem sich auf der gleichen Seite des Kontaktelements (1) befindlichen Wandteil (24;31;33;36) des Profils verbunden ist.

17. Kontaktelement nach einem oder mehreren der Ansprüche 9 bis 16,
**dadurch gekennzeichnet,**
daß bei einem winkel-, C-, oder U-förmigen Profil der Anbindungslappen (8) mit einem mit seinem Längsschenkel fluchtenden oder zu ihm im wesentlichen parallel verlaufenden Schenkel (24) oder Steg (31;36) des Profils verbunden ist.

FIG.1

FIG.2

FIG.3

FIG.4

FIG.5

FIG.6

FIG.7

FIG.8

FIG.9

FIG.10

FIG.11

FIG.12

FIG.13

FIG.14

FIG.15

FIG.16

FIG.17

2

9  2

8

37

38

37,38

L

11,11f

11,11f

36

36

27

7  42

11,11f

37

38

2

6

41

b

39  36  43

FIG.18

Europäisches
Patentamt

**EUROPÄISCHER
RECHERCHENBERICHT**

Nummer der Anmeldung

**EP 90 11 3739**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | FR-A-2 403 711 (LUCAS INDUSTRIES)<br>* Seite 1, Zeilen 10 - 22; Figur 2 *<br>– – – | 1-5,7-8 | H 01 R 9/09 |
| Y | JEE JOURNAL OF ELECTRONIC ENGINEERING. vol. 26, no. 273, September 1989, TOKYO JP Seiten 104 - 106; Tsuneo Miura: "Chip LEDs Enhance SMT"<br>* Seite 105, linke Spalte, letzter Absatz; Figur 4 *<br>– – – | 1-5,7-8 | |
| A | DE-A-1 540 154 (MALCO MANUFACTURING)<br>* Seite 11, letzter Absatz; Figuren 6, 8 *<br>– – – | 6 | |
| A | EP-A-0 043 165 (DU PONT)<br>* Seite 11, Zeile 8 - Seite 17; Figuren 10, 13 *<br>– – – | 10-20 | |
| A | SOLID STATE TECHNOLOGY. vol. 30, no. 9, September 1987, WASHINGTON US Seiten 51 - 52; P.A.Danner, R.A.Bruce: "Fabrication of a Two-Sided Surface Mount Printed Circuit Board"<br>* Seite 51, linke Spalte, Absatz 2 *<br>– – – – – | 1 | |

| RECHERCHIERTE SACHGEBIETE (Int. Cl.5) |
|---|
| H 01 R<br>H 05 K |

Der vorliegende Recherchenbericht wurde für alle Patentansprüche erstellt

| Recherchenort | Abschlußdatum der Recherche | Prüfer |
|---|---|---|
| Den Haag | 12 November 90 | SIBILLA S.E. |